# EUROPEAN PATENT APPLICATION

(11) **EP 4 831 979 A1**
(43) Date of publication of application: **28.10.2026**
(21) Application number: 24907869.2
(22) Date of filing: 29.11.2024
(51) Int. Cl.: G09G 3/3266, H10D 30/67, H10D 86/00, G06F 3/041, H10K 59/40

(54) **SCAN DRIVING UNIT, AND DISPLAY DEVICE INCLUDING SAME**

(30) Priority: 21.12.2023 KR 20230188698
(71) Applicant: Samsung Display Co., Ltd., Yongin-si, Gyeonggi-do 17113 (KR)
(72) Inventor: SEO, Young Wan, Yongin-si Gyeonggi-do 17113 (KR); KIM, Hae Min, Yongin-si Gyeonggi-do 17113 (KR); LEE, Geun Ho, Yongin-si Gyeonggi-do 17113 (KR)
(74) Representative: Marks & Clerk LLP
(86) International application number: PCT/KR2024/019356
(87) International publication number: WO 2025/135584

(57) **Abstract**

The present disclosure relates to a scan driver and a display device including the same. According to an embodiment of the disclosure, a scan driver comprising stages which sequentially output scan signals to scan signal lines during an active period of an N-th frame, wherein N is a positive integer, and at least one of the stages comprises an output node controller supplying a gate-on voltage to a pull-up node in response to a gate control signal of a display driver; and an output controller outputting a scan clock signal, which is input to a scan clock terminal, to a connected scan signal line as a scan signal when the gate-on voltage is supplied to the pull-up node, wherein the output node controller comprises at least one thin-film transistor which includes a first active layer, and is indirectly connected to the pull-up node, and at least another one thin-film transistor which includes a second active layer in which an oxide semiconductor material different from the oxide semiconductor material of the first active layer, and is directly connected to the pull-up node.

## Description

### [Technical Field]

The present disclosure relates to a scan driver and a display device including the same.

### [Background of the Invention]

As the information society develops, demands for display devices for displaying images are increasing in various forms. For example, display devices are applied to various electronic devices such as smartphones, digital cameras, notebook computers, navigation devices, and smart televisions.

The display devices may be flat panel display devices such as liquid crystal display devices, quantum dot display devices, and organic light emitting display devices.

A display device includes a display panel which includes data lines, scan signal lines and a plurality of pixels connected to the data lines and the scan signal lines, a scan driver which supplies scan signals to the scan signal lines, and a data driver which supplies data voltages to the data lines.

The scan driver may be formed in a non-display area of the display panel. The scan driver formed in the display panel includes a plurality of thin-film transistors which are turned on and off in response to gate control signals. Since the thin-film transistors of the scan driver are kept turned on or off for a certain period of time, the operating characteristics, such as operating conditions, of the thin-film transistors must be kept constant.

### [Summary of the Invention]

### [Aspects to be Achieved by the Invention]

Aspects of the present disclosure provide a scan driver capable of improving the material of a semiconductor layer to reduce electrical stress of thin-film transistors by which is subjected to stress due to current amount or voltage bootstrapping, and a display device including the scan driver.

Aspects of the present disclosure also provide a scan driver capable of raising or adjusting electrical characteristics by improving the material of a semiconductor layer of at least one thin-film transistor directly connected to a pull-up node of each scan signal output stage, and a display device including the scan driver.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

### [Means for Achieving the Aspects of the Invention]

According to an embodiment of the disclosure, a scan driver comprising stages which sequentially output scan signals to scan signal lines during an active period of an N-th frame, wherein N is a positive integer, and at least one of the stages comprises an output node controller supplying a gate-on voltage to a pull-up node in response to a gate control signal of a display driver; and an output controller outputting a scan clock signal, which is input to a scan clock terminal, to a connected scan signal line as a scan signal when the gate-on voltage is supplied to the pull-up node.

In an embodiment, the output node controller comprises at least one thin-film transistor which includes a first active layer, and is indirectly connected to the pull-up node, and at least another one thin-film transistor which includes a second active layer in which a hetero-oxide semiconductor material different from the oxide semiconductor material of the first active layer, and is directly connected to the pull-up node.

According to an embodiment of the disclosure, a display device comprising a plurality of pixels arranged in a display area of a display panel, a touch sensing unit mounted on the front of the display panel and integrally formed with the display panel, a touch driver sensing a touch using a plurality of touch electrodes arranged in the touch sensing unit, a display driver controlling data voltages supplied to the pixels and image display timing of the pixels, and a scan driver sequentially driving scan signal lines, which are connected to the pixels, in response to a gate control signal from the display driver.

In an embodiment, the scan driver comprises stages which sequentially output scan signals to the scan signal lines during an active period of an N-th frame, wherein N is a positive integer, and at least one of the stages comprise an output node controller supplying a gate-on voltage to a pull-up node in response to a gate control signal of a display driver, and an output controller outputting a scan clock signal, which is input to a scan clock terminal, to a connected scan signal line as a scan signal when the gate-on voltage is supplied to the pull-up node.

In an embodiment, the output node controller comprises at least one thin-film transistor comprising a first active layer and is indirectly connected to the pull-up node, and at least another one thin-film transistor comprising a second active layer comprising an oxide semiconductor material different from the first active layer, and is indirectly connected to the pull-up node.

### [Effects of the Invention]

A scan driver and a display device including the same according to embodiments can reduce the electrical stress of thin-film transistors and improve reliability by improving the material of a semiconductor layer of a thin-film transistor which is subjected to stress due to the current amount or voltage bootstrapping, etc.

In addition, a scan driver and a display device including the same according to embodiments can increase or stabilize electrical characteristics such as high-speed driving, operating range variation, and threshold voltage fluctuation suppression by improving the material of a semiconductor layer ofat least one thin-film transistor directly connected to a pull-up node of each scan signal output stage.

However, the effects of the present disclosure are not restricted to the one set forth herein. The above and other effects of the present disclosure will become more apparent to one of daily skill in the art to which the present disclosure pertains by referencing the claims.

### [Brief Description of the Drawings]

FIG. 1 is a perspective view of a display device according to an embodiment;
FIG. 2 is a cross-sectional view of the display device according to the embodiment;
FIG. 3 is a plan view of a display unit of the display device according to the embodiment;
FIG. 4 is a block diagram of a display panel and a display driver according to an embodiment;
FIG. 5 is an example diagram of a scan driver according to an embodiment of the present disclosure;
FIG. 6 is a detailed circuit diagram of a first embodiment of an nth stage of the scan driver illustrated in FIG. 5;
FIG. 7 is a waveform diagram illustrating changes in the voltage levels of sensing control signals, scan clock signals, and a pull-up node during an active period of an Nth frame period;
FIG. 8 is a detailed circuit diagram of a second embodiment of the nth stage of the scan driver illustrated in FIG. 5;
FIG. 9 is a cross-sectional view illustrating the cross-sectional structure of first and sixth transistors of the scan driver illustrated in FIG. 8;
FIG. 10 is a diagram of another embodiment of an nth stage of the scan driver illustrated in FIG. 8;
FIG. 11 is a cross-sectional view illustrating the cross-sectional structure of fourth and sixth transistors of the scan driver illustrated in FIG. 10;
FIGS. 12 and 13 are perspective views of an application example of a display device according to an embodiment of the present disclosure; and
FIGS. 14 and 15 are perspective views of an application example of a display device according to another embodiment of the present disclosure.

### [Detailed Description of the Preferred Embodiments]

The present disclosure will now be described more fully hereinafter with reference to the accompanying drawings, in which preferred embodiments of the disclosure are shown. This disclosure may, however, be embodied in different forms and should not be construed as limited to the embodiments set forth herein. Rather, these embodiments are provided so that this disclosure will be thorough and complete, and will filly convey the scope of the disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, specific embodiments will be described with reference to the accompanying drawings.

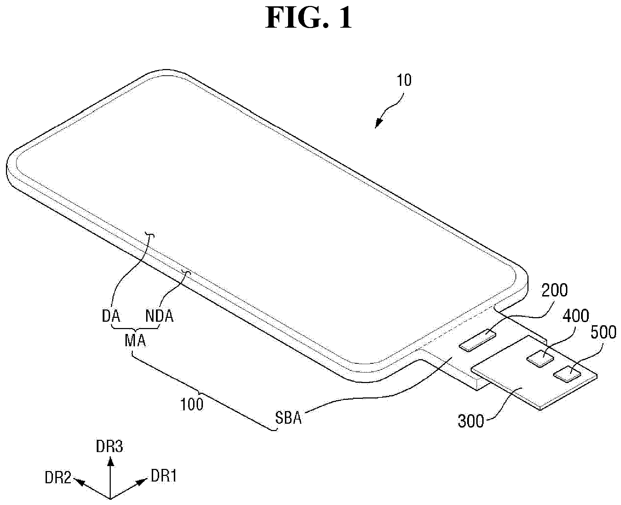

FIG. 1 is a perspective view of a display device according to an embodiment.

Referring to FIG. 1, a display device 10 may be applied to portable electronic devices such as mobile phones, smartphones, tablet personal computers (PCs), mobile communication terminals, electronic notebooks, electronic books, portable multimedia players (PMPs), navigation devices, and ultra-mobile PCs (UMPCs). For example, the display device 10 may be applied as a display unit of a television, a notebook computer, a monitor, a billboard, or an Internet of things (IoT) device. For another example, the display device 10 may be applied to wearable devices such as smart watches, watch phones, glasses-type displays, and head mounted displays (HMDs).

The display device 10 may have a planar shape similar to a quadrangle. For example, the display device 10 may have a planar shape similar to a quadrangle having short sides in a first direction DR1 and long sides in a second direction DR2. Each corner where a short side extending in the first direction DR1 meets a long side extending in the second direction DR2 may be rounded with a predetermined curvature or may be right-angled. The planar shape of the display device 10 is not limited to the quadrangular shape but may also be similar to other polygonal shapes, a circular shape, or an elliptical shape.

The display device 10 may include a display panel 100, a display driver 200, a circuit board 300, a touch driver 400, and a power supply unit 500.

The display panel 100 may include a main area MA and a sub-area SBA.

The main area MA may include a display area DA including pixels that display an image and a non-display area NDA disposed around the display area DA. The display area DA may emit light from a plurality of emission areas or a plurality of opening areas. For example, the display panel 100 may include pixel circuits including switching elements, a pixel defining layer defining the emission areas or the opening areas, and self-light emitting elements.

For example, each of the self-light emitting elements may include, but is not limited to, at least one of an organic light emitting diode including an organic light emitting layer, a quantum dot light emitting diode including a quantum dot light emitting layer, an inorganic light emitting diode including an inorganic semiconductor, and a micro light emitting diode.

The non-display area NDA may be an area outside the display area DA. The non-display area NDA may be defined as an edge area of the main area MA of the display panel 100. The non-display area NDA may include a gate driver (not illustrated) which supplies gate signals to gate lines and fan-out lines (not illustrated) which connect the display driver 200 and the display area DA.

The sub-area SBA may extend from a side of the main area MA. The sub-area SBA may include a flexible material that can be bent, folded, rolled, etc. For example, when the sub-area SBA is bent, it may be overlapped by the main area MA in a thickness direction (e.g., a third direction DR3). The sub-area SBA may include the display driver 200 and pad units connected to the circuit board 300. Optionally, the sub-area SBA may be omitted, and the display driver 200 and the pad units may be disposed in the non-display area NDA.

The display driver 200 may output signals and voltages for driving the display panel 100. The display driver 200 may supply data voltages to data lines DL. The display driver 200 may supply a power supply voltage to a power line and supply a gate control signal to a scan driver (or the gate driver). The display driver 200 may be formed as an integrated circuit (IC)and mounted on the display panel 100 by a chip on glass (COG) method, a chip on plastic (COP) method, or an ultrasonic bonding method. For example, the display driver 200 may be disposed in the sub-area SBA and may be overlapped by the main area MA in the thickness direction (third direction DR3) by the bending of the sub-area SBA. For another example, the display driver 200 may be mounted on the circuit board 300.

The circuit board 300 may be attached onto the pad units of the display panel 100 using an anisotropic conductive layer. Lead lines of the circuit board 300 may be electrically connected to the pad units of the display panel 100. The circuit board 300 may be a flexible printed circuit board, a printed circuit board, or a flexible film such as a chip on film.

The touch driver 400 may be mounted on the circuit board 300. The touch driver 400 may be electrically connected to a touch sensing unit of the display panel 100. The touch driver 400 may supply a touch driving signal to a plurality of touch electrodes of the touch sensing unit and sense a change in capacitance between the touch electrodes. For example, the touch driving signal may be a pulse signal having a predetermined frequency. The touch driver 400 may determine whether an input has been made and calculate coordinates of the input based on a change in capacitance between the touch electrodes. The touch driver 400 may be formed as an integrated circuit (IC).

The power supply unit 500 may be disposed on the circuit board 300 to supply a power supply voltage to the display driver 200 and the display panel 100. The power supply unit 500 may generate a first driving voltage and supply the first driving voltage to first driving voltage lines VDL, may generate an initialization voltage and supply the initialization voltage to initialization voltage lines VIL, and may generate a common voltage and supply the common voltage to a common electrode common to light emitting elements of a plurality of pixels. For example, the first driving voltage may be a high potential voltage for driving the light emitting elements, and each of the common voltage and the second driving voltage may be a low potential voltage for driving the light emitting elements.

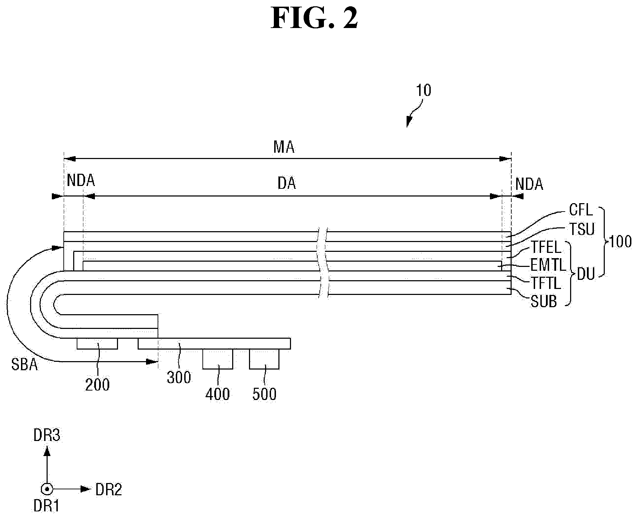

FIG. 2 is a cross-sectional view of the display device according to the embodiment.

Referring to FIG. 2, the display panel 100 may include a display unit DU, a touch sensing unit TSU, and a color filter layer CFL. The display unit DU may include a substrate SUB, a thin-film transistor layer TFTL, a light emitting element layer EMTL, and an encapsulation layer TFEL.

The substrate SUB may be a base substrate or a base member. The substrate SUB may be a flexible substrate that can be bent, folded, rolled, etc. For example, the substrate SUB may include polymer resin such as polyimide (PI), but the present disclosure is not limited thereto. For another example, the substrate SUB may include a glass material or a metal material.

The thin-film transistor layer TFTL may be disposed on the substrate SUB. The thin-film transistor layer TFTL may include a plurality of thin-film transistors constituting pixel circuits of pixels. The thin-film transistor layer TFTL may further include gate lines, data lines DL, power lines, gate control lines, fan-out lines connecting the display driver 200 and the data lines DL, and lead lines connecting the display driver 200 and pad units. Each of the thin-film transistors may include a semiconductor region, a source electrode, a drain electrode, and a gate electrode. For example, when the scan driver (e.g., the gate driver) is formed on a side of the non-display area NDA of the display panel 100, it may include thin-film transistors.

The thin-film transistor layer TFTL may be disposed in the display area DA, the non-display area NDA, and the sub-area SBA. The thin-film transistors of the pixels, the gate lines, the data lines DL, and the power lines of the thin-film transistor layer TFTL may be disposed in the display area DA. The gate control lines and the fan-out lines of the thin-film transistor layer TFTL may be disposed in the non-display area NDA. The lead lines of the thin-film transistor layer TFTL may be disposed in the sub-area SBA.

The light emitting element layer EMTL may be disposed on the thin-film transistor layer TFTL. The light emitting element layer EMTL may include a plurality of light emitting elements, each including a pixel electrode, a light emitting layer and a common electrode sequentially stacked to emit light, and a pixel defining layer defining the pixels. The light emitting elements of the light emitting element layer EMTL may be disposed in the display area DA.

The light emitting layer may be an organic light emitting layer including an organic material. The light emitting layer may include a hole transporting layer, an organic light emitting layer, and an electron transporting layer. When the pixel electrode receives a predetermined voltage through a thin-film transistor of the thin-film transistor layer TFTL and the common electrode receives a cathode voltage, holes and electrons may move to the organic light emitting layer through the hole transporting layer and the electron transporting layer, respectively. Then, the holes and the electrons may be combined with each other in the organic light emitting layer to emit light. For example, the pixel electrode may be an anode electrode, and the common electrode may be a cathode electrode, but the present disclosure is not limited thereto.

For another example, each of the light emitting elements may include a quantum dot light emitting diode including a quantum dot light emitting layer, an inorganic light emitting diode including an inorganic semiconductor, or a micro light emitting diode.

The encapsulation layer TFEL may cover upper and side surfaces of the light emitting element layer EMTL and may protect the light emitting element layer EMTL. The encapsulation layer TFEL may include at least one inorganic layer and at least one organic layer to encapsulate the light emitting element layer EMTL.

The touch sensing unit TSU may be disposed on the encapsulation layer TFEL. The touch sensing unit TSU may include a plurality of touch electrodes for sensing a user's touch in a capacitive manner and touch lines connecting the touch electrodes and the touch driver 400. For example, the touch sensing unit TSU may sense a user's touch in a mutual capacitance manner or a self-capacitance manner.

For another example, the touch sensing unit TSU may be disposed on a separate substrate disposed on the display unit DU. In this case, the substrate that supports the touch sensing unit TSU may be a base member that encapsulates the display unit DU.

The touch electrodes of the touch sensing unit TSU may be disposed in a touch sensor area overlapping the display area DA. The touch lines of the touch sensing unit TSU may be disposed in a touch peripheral area overlapping the non-display area NDA.

The color filter layer CFL may be disposed on the touch sensing unit TSU. The color filter layer CFL may include a plurality of color filters corresponding to a plurality of emission areas, respectively. Each of the color filters may selectively transmit light of a specific wavelength and block or absorb light of other wavelengths. The color filter layer CFL may absorb a part of light coming from the outside of the display device 10, thereby reducing reflected light caused by the external light. Therefore, the color filter layer CFL can prevent color distortion caused by reflection of external light.

Since the color filter layer CFL is directly disposed on the touch sensing unit TSU, the display device 10 may not require a separate substrate for the color filter layer CFL. Therefore, a thickness of the display device 10 can be relatively reduced.

The sub-area SBA of the display panel 100 may extend from a side of the main area MA. The sub-area SBA may include a flexible material that can be bent, folded, rolled, etc. For example, when the sub-area SBA is bent, it may be overlapped by the main area MA in the thickness direction (third direction DR3). The sub-area SBA may include the display driver 200 and the pad units electrically connected to the circuit board 300.

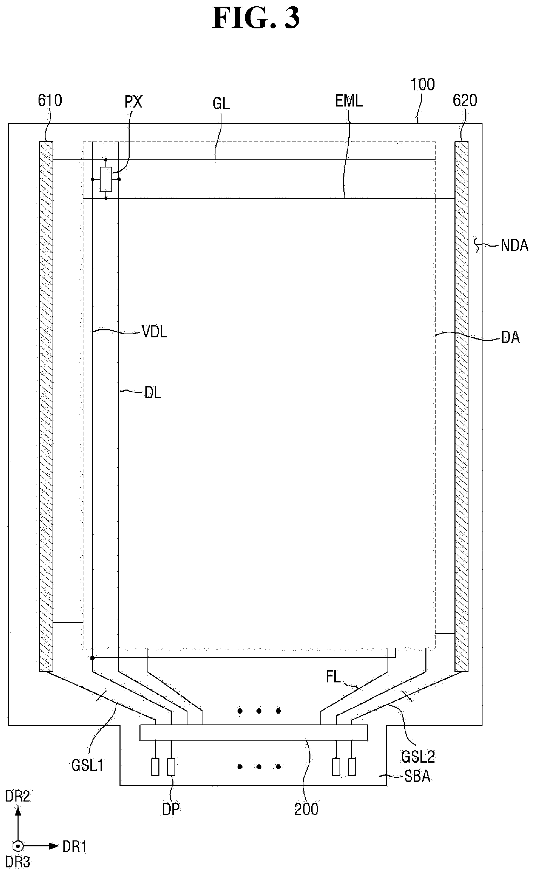

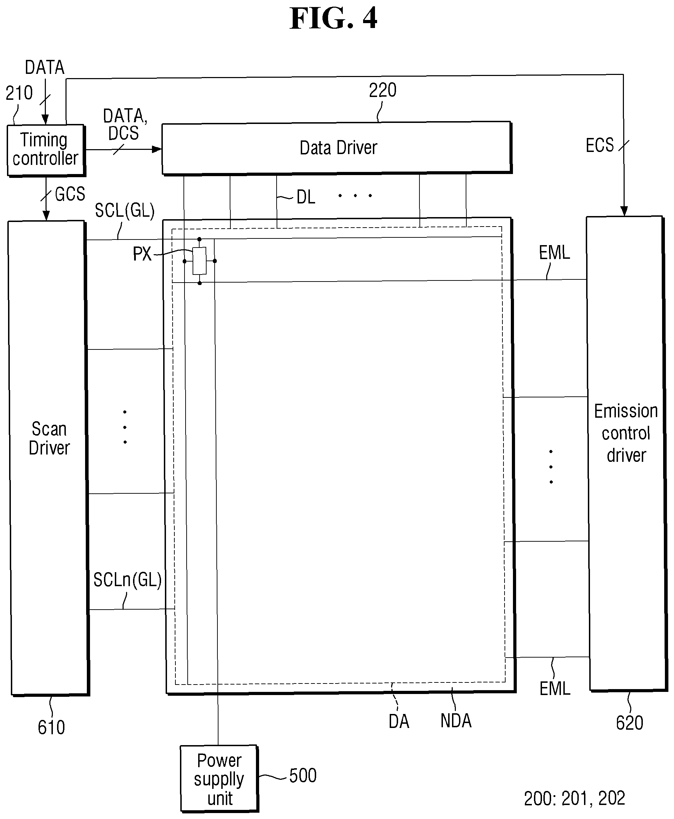

FIG. 3 is a plan view of a display unit of the display device according to the embodiment. FIG. 4 is a block diagram of a display panel and a display driver according to an embodiment.

Referring to FIGS. 3 and 4, the display panel 100 may include the display area DA and the non-display area NDA.

The display area DA may include a plurality of pixels PX, a plurality of first driving voltage lines VDL connected to the pixels PX, a plurality of second driving voltage lines, a plurality of gate lines GL, a plurality of emission control lines EML, and a plurality of data lines DL.

Each of the pixels PX may be connected to a gate line GL, a data line DL, an emission control line EML, a first driving voltage line VDL, and a second driving voltage line. Each of the pixels PX may include at least one transistor, a light emitting element, and a capacitor.

The gate lines GL may extend in the first direction DR1 and may be spaced apart from each other in the second direction DR2 intersecting the first direction DR1. The gate lines GL may be arranged along the second direction DR2. The gate lines GL may sequentially supply gate signals to the pixels PX.

The emission control lines EML may extend in the first direction DR1 and may be spaced apart from each other in the second direction DR2. The emission control lines EML may be arranged along the second direction DR2. The emission control lines EML may sequentially supply emission control signals to the pixels PX.

The data lines DL may extend in the second direction DR2 and may be spaced apart from each other in the first direction DR1. The data lines DL may be arranged along the first direction DR1. The data lines DL may supply data voltages to the pixels PX. The data voltage may determine luminance of each of the pixels PX.

The first driving voltage lines VDL may extend in the second direction DR2 and may be spaced apart from each other in the first direction DR1. The first driving voltage lines VDL may be arranged along the first direction DR1. The first driving voltage lines VDL may supply first driving voltages to the pixels PX. The first driving voltages may be high potential voltages for driving the light emitting elements of the pixels PX.

The non-display area NDA may surround the display area DA. The non-display area NDA may include a scan driver 610, an emission control driver 620, fan-out lines FL, a first gate control line GSL1, and a second gate control line GSL2.

The fan-out lines FL may extend from the display driver 200 to the display area DA. The fan-out lines FL may supply data voltages received from the display driver 200 to the data lines DL.

The first gate control line GSL1 may extend from the display driver 200 to the scan driver 610. The first gate control line GSL1 may supply a gate control signal GCS received from the display driver 200 to the scan driver 610.

The second gate control line GSL2 may extend from the display driver 200 to the emission control driver 620. The second gate control line GSL2 may supply an emission control signal ECS received from the display driver 200 to the emission control driver 620.

The sub-area SBA may extend from a side of the non-display area NDA. The sub-area SBA may include the display driver 200 and pad units DP. The pad units DP may be disposed closer to an edge of the sub-area SBA than the display driver 200. The pad units DP may be electrically connected to the circuit board 300 through an anisotropic conductive film (ACF).

The display driver 200 may include a timing controller 210 and a data driver 220.

The timing controller 210 may receive digital video data DATA and timing signals from the circuit board 300. The timing controller 210 may control the operation timing of the data driver 220 by generating a data control signal DCS based on the timing signals, may control the operation timing of the scan driver 610 by generating the gate control signal GCS, and may control the operation timing of the emission control driver 620 by generating the emission control signal ECS. The timing controller 210 may supply the gate control signal GCS to the scan driver 610 through the first gate control line GSL1. The timing controller 210 may supply the emission control signal ECS to the emission control driver 620 through the second gate control line GSL2. The timing controller 210 may supply the digital video data DATA and the data control signal DCS to the data driver 220.

The data driver 220 may convert the digital video data DATA into analog data voltages and supply the analog data voltages to the data lines DL through the fan-out lines FL. Gate signals of the scan driver 610 may select pixels PX to which the data voltages are to be supplied, and the selected pixels PX may receive the data voltages through the data lines DL.

The power supply unit 500 may be disposed on the circuit board 300 to supply power supply voltages to the display driver 200 and the display panel 100. The power supply unit 500 may generate first driving voltages and supply the first driving voltages to the first driving voltage lines VDL, may generate initialization voltages and supply the initialization voltages to the initialization voltage lines VIL, and may generate a common voltage and supply the common voltage to the common electrode common to the light emitting elements of the pixels PX.

The scan driver 610 may be disposed outside one side of the display area DA or on one side of the non-display area NDA, and the emission control driver 620 may be disposed outside the other side of the display area DA or on the other side of the non-display area NDA. However, the present disclosure is not limited thereto. For another example, the scan driver 610 and the emission control driver 620 may be disposed on either one side or the other side of the non-display area NDA.

The scan driver 610 may include a plurality of transistors that generate gate signals based on the gate control signal GCS. The emission control driver 620 may include a plurality of transistors that generate emission control signals based on the emission control signal ECS. For example, the transistors of the scan driver 610 and the transistors of the emission control driver 620 may be formed on the same layer as the transistors of the pixels PX. The scan driver 610 may supply the gate signals to the gate lines GL, and the emission control driver 620 may supply the emission control signals to the emission control lines EML.

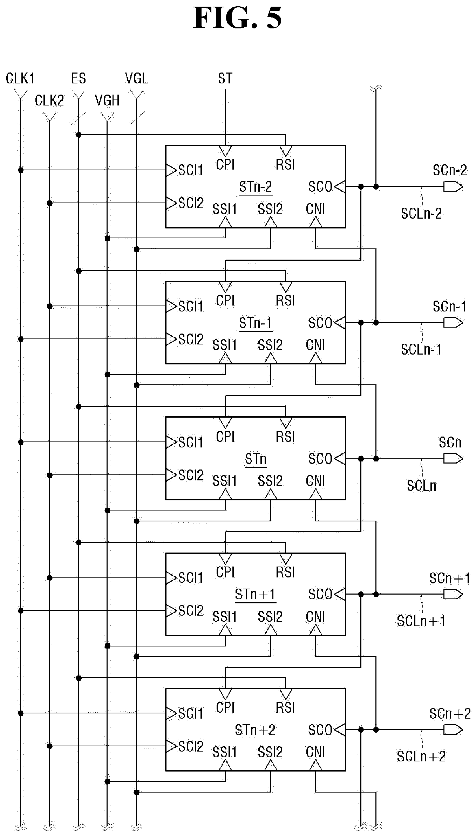

FIG. 5 is an example diagram of a scan driver according to an embodiment of the present disclosure.

Referring to FIG. 5, the scan driver 610 according to the embodiment includes a plurality of stages that are dependently connected to each other, that is, nth stages STn. Here, n is a positive integer.

In FIG. 5, for ease of description, only (n-2)th through (n+2)th stages STn-2 through STn+2 are illustrated based on an nth stage STn.

In the following description, a "previous stage" refers to a stage located in front of the nth stage STn. A "next stage" refers to a stage located behind the nth stage STn. For example, a previous stage of the nth stage STn indicates the (n-1)th stage STn-1, and a next stage of the nth stage STn indicates the (n+1)th stage STn+1.

Scan clock lines and sensing control lines may be disposed on one side of the (n-2)th through (n+2)th stages STn-2 through STn+2. A plurality of scan clock signals CLK1 and CLK2 whose phases are sequentially delayed or alternated are applied to the scan clock lines, respectively, and a start signal ST, a line selection signal ES and a reset signal are transmitted to the sensing control lines, respectively.

The scan clock signals CLK1 and CLK2, the line selection signal ES, the start signal ST, and the reset signal may be gate control signals GCS generated from the display driver 200 and transmitted through first gate control lines GSL1. In FIG. 5, two scan clock lines, two sensing control lines, and two power lines are illustrated as the first gate control lines GSL1. However, the number of scan clock lines and sensing control lines is not limited thereto.

The scan driver 610 includes the (n-2)th through (n+2)th stages STn-2 through STn+2 connected to the first gate control lines GSL1, respectively. Among the nth stages STn, the (n-2)th stage STn-2 outputs an (n-2)th scan signal SCn-2 to an (n-2)th scan signal line SCLn-2, and the (n-1)th stage STn-1 outputs an (n-1)th scan signal SCn-1 to an (n-1)th scan signal line SCLn-1. Accordingly, the nth stage STn may output an nth scan signal SCn to an nth scan signal line SCLn. Next, the (n+1)th stage STn+1 outputs an (n+1)th scan signal SCn+1 to an (n+1)th scan signal line SCLn+1, and the (n+2)th stage STn+2 outputs an (n+2)th scan signal SCn+2 to an (n+2)th scan signal line SCLn+2.

Each of the (n-2)th through (n+2)th stages STn-2 through STn+2 includes a previous carry terminal CPI, a next carry terminal CNI, a first scan clock terminal SCI1, a second scan clock terminal SCI2, a first power supply terminal SSI1, a second power supply terminal SSI2, a sensing signal terminal RSI, and a scan output terminal SCO.

When the (n-2)th stage STn-2 is a first stage, the start signal ST may be input to the previous carry terminal CPI of the (n-2)th stage STn-2 through a start signal line. The previous carry terminal CPI of each of the stages dependently connected except the first stage may be connected to the scan output terminal SCO of an immediately previous stage. For example, as illustrated in FIG. 5, the previous carry terminal CPI of the nth stage STn may be connected to the scan output terminal SCO of the (n-1)th stage STn-1.

The next carry terminal CNI of each of the (n-2)th through (n+2)th stages STn-2 through STn+2 may be connected to the scan output terminal SCO of any one next stage. For example, as illustrated in FIG. 5, the next carry terminal CNI of the nth stage STn may be connected to the scan output terminal SCO of the (n+1)th stage STn+1 and may receive the scan signal SCn+1 of the (n+1)th stage STn+1 as a next carry signal.

The scan output terminals SCO of the (n-2)th through (n+2)th stages STn-2 through STn+2 are sequentially connected to scan signal lines SCL, which are corresponding gate lines GL, respectively. Accordingly, each of the scan signal lines SCL may be connected one-to-one to the scan output terminals SCO of all stages STn-2 through STn+2. For example, the (n-1)th scan signal line SCLn-1 is connected to the scan output terminal SCO of the (n-1)th stage STn-1, and the nth scan signal line SCLn is connected to the scan output terminal SCO of the nth stage STn. In addition, the (n+1)th scan signal line SCLn+1 may be connected to the scan output terminal SCO of the (n+1)th stage STn+1.

The sensing signal terminal RSI of each of the (n-2)th through (n+2)th stages STn-2 through STn+2 receives the line selection signal ES through a sensing control line to which the line selection signal ES is transmitted.

Each of the (n-2)th through (n+2)th stages STn-2 through STn+2 receives two scan clock signals, that is, first and second scan clock signals CLK1 and CLK2 whose phases are sequentially alternated or delayed through the first scan clock terminal SCI1 and the second scan clock terminal SCI2.

For example, each of the (n-2)th through (n+2)th stages STn-2 through STn+2 may receive the first scan clock signal CLK1 through the first scan clock terminal SCI1 and receive the second scan clock signal CLK2 whose phase is sequentially alternated or delayed from the first scan clock signal CLK1 through the second scan clock terminal SCI2.

The (n-2)th through (n+2)th stages STn-2 through STn+2 sequentially output the scan signals SCn-2 through SCn+2 to the scan signal lines SCLn-2 through SCLn+2 connected one-to-one thereto through their respective scan output terminals SCO, respectively. For example, during at least one frame period, the (n-2)th stage STn-2 transmits the (n-2)th scan signal SCn-2 to the (n-2)th scan signal line SCLn-2 connected to the scan output terminal SCO. Next, the (n-1)th stage STn-1 outputs the (n-1)th scan signal SCn-1 to the (n-1)th scan signal line SCLn-1 connected to the scan output terminal SCO. Accordingly, the nth stage STn outputs the nth scan signal SCn to the nth scan signal line SCLn connected to the scan output terminal SCO. Subsequently, the (n+1)th stage STn+1 may output the (n+1)th scan signal SCn+1 to the (n+1)th scan signal line SCLn+1 connected to the scan output terminal SCO, and the (n+2)th stage STn+2 may output the (n+2)th scan signal SCn+2 to the (n+2)th scan signal line SCLn+2 connected to the scan output terminal SCO.

Overall, the scan driver 610 may be composed of stages ST1 to STn that sequentially output first to nth scan signals SC1 to SCn for each active period during each frame period. Specific structure of the scan driver 610 has been described through FIG. 5

The emission control driver 620 which sequentially generates and outputs emission signals in response to the emission control signal ECS received from the display driver 200 may also be structured to include the (n-2)th through (n+2)th stages STn-2 through STn+2, that is, the nth stages STn. Therefore, a description of the detailed structure of the emission control driver 620 will be replaced with the description of the scan driver 610.

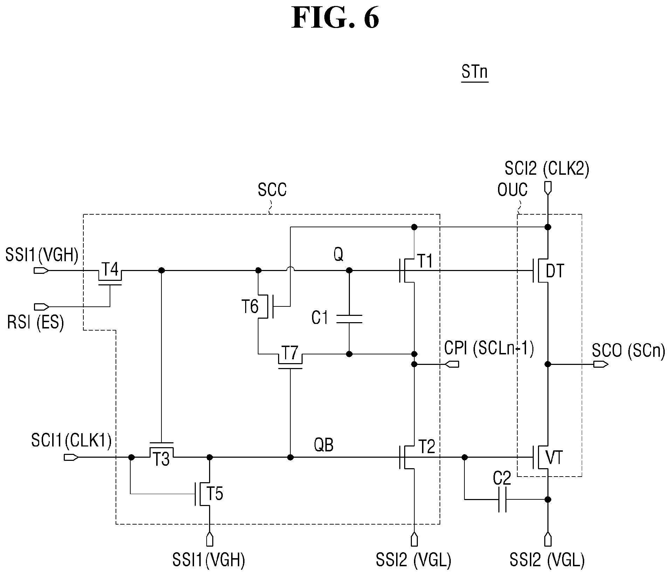

FIG. 6 is a detailed circuit diagram of a first embodiment of an nth stage of the scan driver illustrated in FIG. 5. In particular, FIG. 6 illustrates the nth stage STn among the (n-2)th through (n+2)th stages STn-2 through STn+2 as an example.

The nth stage STn includes an output node controller SCC and an output controller OUC. In addition, the nth stage STn further includes a first power supply terminal SSI1 to which a gate-on voltage VGH is supplied, and a second power supply terminal SSI2 to which a gate-off voltage VGL is supplied.

The nth stage STn may operate in response to the start signal ST received through the previous carry terminal CPI. However, when connected dependently to the previous (n-1)th stage STn-1, the nth stage STn may operate in response to the (n-1)th scan signal SCn-1 of the (n-1)th stage STn-1 received as a carry signal. An example in which the nth stage STn is any one nth stage STn that is dependently connected to the previous (n-1)th stage STn-1 will be described below.

The output node controller SCC of the nth stage STn enables the output controller OUC by supplying a voltage of the same level as the gate-on voltage VGH to a pull-up node Q during the active period of each frame period. While the pull-up node Q is maintained at the level of the gate-on voltage VGH, the gate-off voltage VGL of the second power supply terminal SSI2 is applied to a pull-down node QB.

Specifically, the output node controller SCC supplies the gate-on voltage VGH to the pull-up node Q in response to the line selection signal ES input during the active period or a carry signal of a previous stage, that is, the (n-1)th scan signal SCn-1 of the (n-1)th stage STn-1. Here, the line selection signal ES or the carry signal of the previous stage may be at the level of the gate-on voltage. When the gate-on voltage VGH is applied to the pull-up node Q of the output node controller SCC, the pull-up node Q of the output node control unit SCC is enabled according to the level of the gate-on voltage VGH. The output node controller SCC controls the gate-off voltage VGL to be supplied to the pull-down node QB during a period in which the gate-on voltage VGH is applied to the pull-up node Q.

When the pull-up node Q of the output node controller SCC is enabled, the output controller OUC outputs the nth scan signal SCn to the nth scan signal line SCLn connected to the scan output terminal SCO in response to any one scan clock signal CLK2 of the scan clock signals CLK1 and CLK2.

After the nth scan signal SCn is output, the output node controller SCC controls the gate-off voltage VGL to be supplied to the pull-up node Q in response to any one scan clock signal CLK1 of the scan clock signals CLK1 and CLK2 or the (n+1)th scan signal SCn+1 of the (n+1)th stage STn+1). The pull-up node Q is disabled by the gate-off voltage VGL.

The output node controller SCC enables the pull-down node QB with the gate-on voltage VGH in response to the any one scan clock signal CLK1 of the scan clock signals CLK1 and CLK2 during a period in which the pull-up node Q is disabled.

When the pull-down node QB of the output node controller SCC is enabled, the output controller OUC electrically connects the nth scan signal line SCLn to the second power supply terminal SSI2 to which the gate-off voltage VGL is applied.

The (n-2)th through (n+2)th stages STn-2 through STn+2 output the nth scan signals SCn to their respective scan signal lines SCLn and sequentially and repeatedly perform an operation of maintaining their respective scan signal lines SCLn at the gate-off voltage VGL.

The output node controller SCC of the nth stage STn may include first through seventh transistors T1 through T7 and at least one first capacitor C1. Any one of first and second electrodes of each of the first through seventh transistors T1 through T7 may be a source electrode, and the other may be a drain electrode.

Specifically, a gate electrode of the first transistor T1 may be connected to the pull-up node Q, the first electrode of the first transistor T1 may be connected to the second scan clock terminal SCI2, and the second electrode of the first transistor T1 may be connected to the previous carry terminal CPI and the first electrode of the second transistor T2. The first transistor T1 may be turned on when the pull-up node Q is enabled by the gate-on voltage VGH and may supply the second scan clock terminal SCI2 to the first capacitor C1 and the second transistor T2 connected in parallel.

A gate electrode of the second transistor T2 is connected to the pull-down node QB, and the first electrode of the second transistor T2 is connected to the second electrode of the first transistor T1 and the previous carry terminal CPI. In addition, the second electrode of the second transistor T2 is connected to the second power supply terminal SSI2. The second transistor T2 is turned on when the pull-down node QB is enabled by the gate-on voltage VGH and supplies the gate-off voltage VGL to the first transistor T1.

A gate electrode of the third transistor T3 is connected to the pull-up node Q, and the first electrode of the third transistor T3 is connected to the first scan clock terminal SCI1. In addition, the second electrode of the third transistor T3 is connected to the pull-down node QB. The third transistor T3 may be turned on when the pull-up node Q is enabled by the gate-on voltage VGH and may supply the first scan clock signal CLK1 to the pull-down node QB.

A gate electrode of the fourth transistor T4 is connected to the sensing signal terminal RSI or the previous carry terminal CPI, and the first electrode of the fourth transistor T4 is connected to the first power supply terminal SSI1. In addition, the second electrode of the fourth transistor T4 is connected to the pull-up node Q. The fourth transistor T4 is turned on in response to the line selection signal ES of the sensing signal terminal RSI or the previous carry signal and supplies the gate-on voltage VGH to the pull-up node Q. Accordingly, the fourth transistor T4 may enable the pull-up node Q at the level of the gate-on voltage VGH in response to the line selection signal ES of the sensing signal terminal RSI or the previous carry signal.

A gate electrode of the fifth transistor T5 is connected to the first scan clock terminal SCI1, and the first electrode of the fifth transistor T5 is connected to the first power supply terminal SSI1. In addition, the second electrode of the fifth transistor T5 is connected to the pull-down node QB. The fifth transistor T5 is turned on in response to the first scan clock signal CLK1 and supplies the gate-on voltage VGH to the pull-down node QB. Accordingly, the fifth transistor T5 may enable the pull-down node QB at the level of the gate-on voltage VGH in response to the first scan clock signal CLK1.

A gate electrode of the sixth transistor T6 is connected to the second scan clock terminal SCI2, and the first electrode of the sixth transistor T6 is connected to the pull-up node Q. In addition, the second electrode of the sixth transistor T6 is connected to the second electrode of the first transistor T1 or the first electrode of the seventh transistor T7. Accordingly, the sixth transistor T6 electrically connects the pull-up node Q to the second electrode of the first transistor T1 or the first electrode of the seventh transistor T7 in response to the second scan clock terminal SCI2. The sixth transistor T6 may serve as a diode between the pull-up node Q and the first capacitor C1.

A gate electrode of the seventh transistor T7 is connected to the pull-down node QB, and the first electrode of the seventh transistor T7 is connected to the second electrode of the sixth transistor T6. In addition, the second electrode of the seventh transistor T7 is connected to the second electrode of the first transistor T1 and the first capacitor C1. The seventh transistor T7 is turned on when the pull-down node QB is enabled and electrically connects the second electrode of the sixth transistor T6 to the first capacitor C1 and the second electrode of the first transistor T1. The seventh transistor T7 serves as a diode to keep the sixth transistor T6 and the first transistor T1 turned off during the enable period of the pull-down node QB.

The output controller OUC includes a pull-up transistor DT and a pull-down transistor VT.

The pull-up transistor DT has a first electrode connected to the second scan clock terminal SCI2, a gate electrode connected to the pull-up node Q, and a second electrode connected to the scan output terminal SCO. The pull-up transistor DT is turned on by the gate-on voltage VGH of the pull-up node Q and outputs any one scan clock signal input to the second scan clock terminal SCI2, for example, the second scan clock signal CLK2 to the scan output terminal SCO. Accordingly, the nth scan signal SCn of the gate-on voltage may be supplied to the nth scan signal line SCLn.

The pull-down transistor VT may have a first electrode connected to the scan output terminal SCO, a gate electrode connected to the pull-down node QB, and a second electrode connected to the second power supply terminal SSI2. The pull-down transistor VT is turned on by the gate-on voltage VGH of the pull-down node QB and transmits the gate-off voltage VGL inputted to the second power supply terminal SSI2 to the scan output terminal SCO. Therefore, the nth scan signal line SCLn connected to the scan output terminal SCO may be maintained at the level of the gate-off voltage VGL during the turn-on period of the pull-down transistor VT.

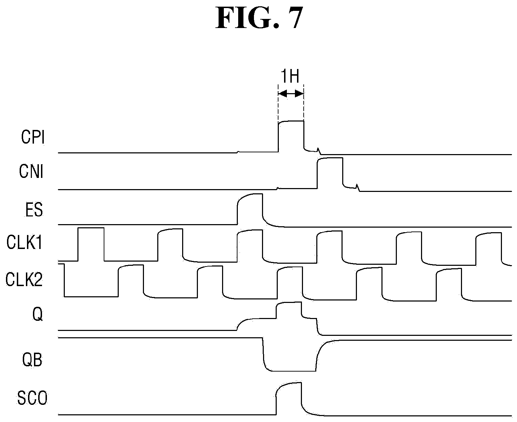

FIG. 7 is a waveform diagram illustrating changes in the voltage levels of sensing control signals, scan clock signals, and a pull-up node during an active period of an Nth frame period.

Referring to FIG. 7, the line selection signal ES, the start signal ST, and the first and second scan clock signals CLK1 and CLK2 are signals that are generated at the level of the gate-on voltage VGH during one horizontal period 1H. The line selection signal ES may be generated every one horizontal period 1H so that the gate-on voltage VGH can be supplied to the pull-up node Q of each of the stages STn-2 through STn+2 during the active period. Even if the line selection signal ES is not generated and supplied, it can be replaced with the start signal ST or a carry signal from a previous stage (i.e., a previous carry signal).

The first and second scan clock signals CLK1 and CLK2 are clock signals whose phases are sequentially delayed or repeatedly alternated. Each of the first and second scan clock signals CLK1 and CLK2 may be generated at the level of the gate-on voltage VGH for at least one horizontal period 1H and may be generated at the level of the gate-off voltage VGL for at least one horizontal period 1H. Here, the generation period, pulse width, and amplitude of each of the first and second scan clock signals CLK1 and CLK2 are not limited to those of FIG. 7 and can be variously changed.

The gate-on voltage VGH may be the gate-high voltage that can turn on transistors included in each of the (n-2)th through (n+2)th stages STn-2 through STn+2 of the scan driver 610 and transistors of subpixels PX. The gate-off voltage VGH may be the gate-low voltage VGL that can turn off the transistors of the (n-2)th through (n+2)th stages STn-2 through STn+2 of the scan driver 610 and the transistors of the subpixels PX.

The operation of the nth stage STn during any one frame will be briefly described below with reference to FIGS. 6 and 7.

First, the fourth transistor T4 is turned on in response to the line selection signal ES of the sensing signal terminal RSI or the start signal ST and supplies the gate-on voltage VGH to the pull-up node Q. Accordingly, the pull-up node Q is enabled.

Next, the first transistor T1 is turned on when the pull-up node Q is enabled by the gate-on voltage VGH and charges the first capacitor C1. In addition, the pull-up transistor DT is turned on by the gate-on voltage VGH of the pull-up node Q and outputs the second scan clock signal CLK2, which is input to the second scan clock terminal SCI2, to the scan output terminal SCO. Accordingly, the pull-up node Q is bootstrapped, and the nth scan signal SCn of the gate-on voltage VGH is supplied to the nth scan signal line SCLn.

Thereafter, the fifth transistor T5 is turned on in response to the first scan clock signal CLK1 and enables the pull-down node QB at the level of the gate-on voltage VGH. The pull-down transistor VT is turned on by the gate-on voltage VGH of the pull-down node QB and transmits the gate-off voltage VGL inputted to the second power supply terminal SSI2 to the scan output terminal SCO. Therefore, the nth scan signal line SCLn connected to the scan output terminal SCO may be maintained at the level of the gate-off voltage VGL during the turn-on period of the pull-down transistor VT.

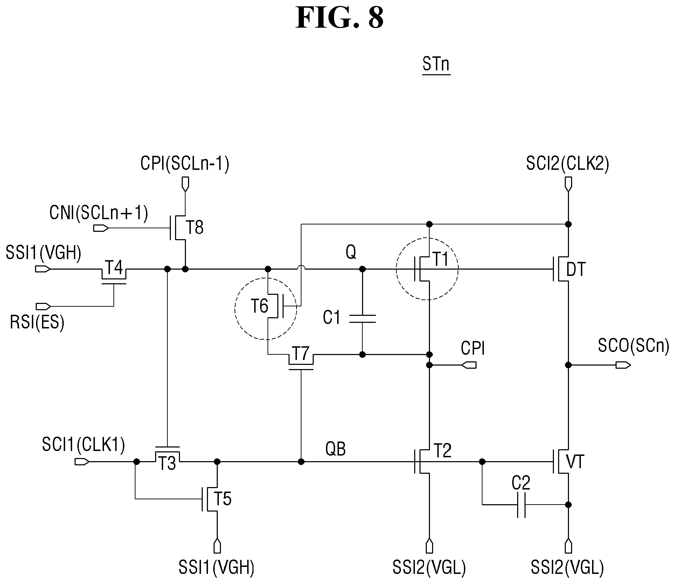

FIG. 8 is a detailed circuit diagram of a second embodiment of the nth stage of the scan driver illustrated in FIG. 5.

Referring to FIG. 8, an output node controller SCC of the nth stage STn may further include an eighth transistor T8 which disables a pull-up node Q with a gate-off voltage VGL in response to a next carry signal from a next stage STn+1.

A gate electrode of the eighth transistor T8 is connected to a next carry terminal CNI, and a first electrode of the eighth transistor T8 is connected to a previous carry terminal CPI or a second power supply terminal SSI2. In addition, a second electrode of the eighth transistor T8 is connected to the pull-up node Q. Accordingly, the eighth transistor T8 may supply the gate-off voltage VGL to the pull-up node Q in response to the next carry signal from the next stage STn+1.

As described above, the output node controllers SCC of all stages, that is, the (n-2)th through (n+2)th stages STn-2 through STn+2 may each include the first through seventh transistors T1 through T7 or the first through eighth transistors T1 through T8. At least one of the first through eighth transistors T1 through T8 of each stage STn, for example, the first transistor T1, the third transistor T3, and the fourth transistor T4 enable the pull-up node Q using the gate-on voltage VGH and, during a period in which the enabled pull-up node Q is bootstrapped to a voltage higher than the gate-on voltage VGH by one scan clock signal CLK2, receive the bootstrapped voltage through any one electrode. Accordingly, the first, third, and fourth transistors T1, T3, and T4 may be subjected to high potential and high voltage stress, and the current and voltage characteristics such as threshold voltage characteristics of their semiconductor layers (or active layers) may be changed by the influence of the high potential and high voltage stress. If the current and voltage characteristics of the first, third, and fourth transistors T1, T3, and T4 are changed, the voltage and current output characteristics of the first, third, and fourth transistors T1, T3, and T4 may deteriorate, thereby reducing the output of each of the stages STn-2 through STn+2 or lowering reliability.

In this regard, the semiconductor layer (or active layer) of at least one of the first through eighth transistors T1 through T8 of each stage STn may be made of a different oxide semiconductor material from the semiconductor layer (or active layer) of at least one other transistor T1 through T8.

For example, the semiconductor layer (or active layer) of at least one transistor T1 through T8 which is directly connected to the pull-up node Q and subjected to high potential and high voltage stress among the first through eighth transistors T1 through T8 of each stage STn may include a different heterogeneous oxide semiconductor material from the semiconductor layer (or active layer) of at least one other transistor T1 through T8 which is not directly connected to the pull-up node Q.

In particular, the semiconductor layers (or active layers) of the first, third, and fourth transistors T1, T3, and T4 directly connected to the pull-up node Q among the first through eighth transistors T1 through T8 of each stage STn may be made of a different heterogeneous oxide semiconductor material that increases a current amount range. Accordingly, the current amount and current transfer speed of the first, third, and fourth transistors T1, T3, and T4 can be increased.

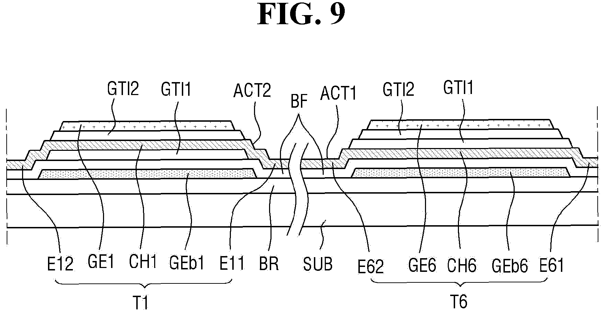

FIG. 9 is a cross-sectional view illustrating the cross-sectional structure of first and sixth transistors of the scan driver illustrated in FIG. 8.

Referring to FIGS. 8 and 9, at least one transistor indirectly connected to the pull-up node Q, for example, the second and fifth through seventh transistors T2, T5, T6 and T7 among a plurality of transistors T1 through T8 included in each stage STn, include a first active layer ACT1 including an oxide semiconductor.

On the other hand, at least one transistor directly connected to the pull-up node Q, for example, the first, third, fourth and eighth transistors T1, T3, T4 and T8 among the transistors T1 through T8 included in each stage STn, include a second active layer ACT2 including a hetero-oxide semiconductor different from the oxide semiconductor of the first active layer ACT1.

Specifically, a barrier layer BR is formed on the substrate SUB on which each stage STn is formed, and the thin-film transistor layer TFTL including a plurality of transistors T1 through T8 of each stage STn is formed on the barrier layer BR.

The substrate SUB may be a rigid substrate or a flexible substrate that can be bent, folded, or rolled. The substrate SUB may be made of an insulating material such as glass, quartz, or polymer resin. The polymer material may be, for example, polyethersulphone (PES), polyacrylate (PA), polyarylate (PAR), polyetherimide (PEI), polyethylene naphthalate (PEN), polyethylene terepthalate (PET), polyphenylene sulfide (PPS), polyallylate, polyimide (PI), polycarbonate (PC), cellulose triacetate (CAT), cellulose acetate propionate (CAP), or a combination thereof. Alternatively, the substrate SUB may include a metal material.

The barrier layer BR may be disposed on the substrate SUB. The barrier layer BR may be a layer for protecting the thin-film transistor layer TFTL from moisture introduced through the substrate SUB which is vulnerable to moisture penetration. The barrier layer BR may be composed of a plurality of inorganic layers stacked alternately. For example, the barrier layer BR may be a multilayer in which one or more inorganic layers selected from a silicon nitride layer, a silicon oxynitride layer, a silicon oxide layer, a titanium oxide layer, and an aluminum oxide layer are alternately stacked.

The thin-film transistor layer TFTL including a plurality of transistors T1 through T8 of each stage STn is formed on the barrier layer BR.

The thin-film transistor layer TFTL of at least one transistor indirectly connected to the pull-up node Q, for example, the thin-film transistor layer TFTL of the sixth transistor T6 includes a first gate electrode GEb1, an interlayer insulating layer BF, the first active layer ACT1, first and second gate insulating layers GTI1 and GTI2, and a second gate electrode GE6.

The interlayer insulating layer BF is formed to cover the barrier layer BR as well as the first gate electrode GEb1.

The first active layer ACT1 is formed to cover the first gate electrode GEb1with the interlayer insulating layer BF interposed between them, thereby forming a sixth channel region CH6. A first electrode E61 and a second electrode E62 may be defined on one side and the other side of the first active layer ACT1, respectively.

The first gate insulating layer GTI1 is formed to overlap the first gate electrode GEb1 with the first active layer ACT1 interposed between them, and the second gate insulating layer GTI2 is formed to overlap the first gate electrode GEb1 with the first gate insulating layer GTI1 interposed between them.

The second gate electrode GE6 is formed to overlap the first gate electrode GEb1 with the first and second gate insulating layers GTI1 and GTI2 interposed between them.

The interlayer insulating layer BF may include an inorganic layer, for example, a silicon nitride layer, a silicon oxynitride layer, a silicon oxide layer, a titanium oxide layer, or an aluminum oxide layer. The interlayer insulating layer BF may include a plurality of inorganic layers.

The first active layer ACT1 may include polycrystalline silicon, monocrystalline silicon, low-temperature polycrystalline silicon, amorphous silicon, or an oxide semiconductor material. When the first active layer ACT1 includes an oxide semiconductor material, it may include indium-gallium-zinc-oxide (IGZO).

When the first active layer ACT1 includes polycrystalline silicon or an oxide semiconductor material, a source region and a drain region in the first active layer ACT1 may be conductive regions doped with ions to have conductivity.

The first gate insulating layer GTI1 may include at least one of tetraethylorthosilicate (TEOS), silicon nitride (SiNx), and silicon oxide (SiO2). For example, the first gate insulating layer GTI1 may have a double-layer structure in which a silicon nitride layer with a thickness of 40 nm and a tetraethylorthosilicate layer with a thickness of 80 nm are sequentially stacked. The second gate insulating layer GTI2 may include the same material and structure as the first gate insulating layer GTI1 described above.

Meanwhile, at least one transistor directly connected to the pull-up node Q, for example, the first, third, fourth and eighth transistors T1, T3, T4 and T8 among the transistors T1 through T8 included in each stage STn include the second active layer ACT2 including a hetero-oxide semiconductor different from the oxide semiconductor of the first active layer ACT1.

For example, the thin-film transistor layer TFTL of the first transistor T1 directly connected to the pull-up node Q includes a first gate electrode GEb1, the interlayer insulating layer BF, the second active layer ACT2, the first and second gate insulating layers GTI1 and GTI2, and a second gate electrode GE5.

The interlayer insulating layer BF is formed to cover the barrier layer BR as well as the first gate electrode GEb1.

The second active layer ACT2 is formed to cover the first gate electrode GEb1 with the interlayer insulating layer BF interposed between them, thereby forming a first channel region CH1. A first electrode E61 and a second electrode E62 may be defined on one side and the other side of the second active layer ACT2, respectively.

The first gate insulating layer GTI1 is formed to overlap the first gate electrode GEb1 with the second active layer ACT2(or the interlayer insulating layer BF) interposed between them, and the second gate insulating layer GTI2 is formed to overlap the first gate electrode GEb1 with the first gate insulating layer GTI1 (or the second active layer ACT2) interposed between them.

The second gate electrode GE6 is formed to overlap the first gate electrode GEb1 with the first and second gate insulating layers GTI1 and GTI2 (or the second gate insulating layer GTI2 and the second active layer ACT2) interposed between them.

The second active layer ACT2 may include a different hetero-oxide semiconductor material from the first active layer ACT1. For example, when the first active layer ACT1 is an oxide semiconductor including indium-gallium-zinc-oxide (IGZO), the second active layer ACT2 may be an oxide semiconductor including indium-gallium-zinc-tin oxide (IGZTO). When the second active layer ACT2 includes a different heterogeneous oxide semiconductor material from the first active layer ACT1, a source region and a drain region in the second active layer ACT2 may be conductive regions doped with ions to have conductivity.

Since the first active layer ACT1 and the second active layer ACT2 are semiconductor layers made of different materials, they may be formed on the substrate SUB through different processes.

The second and fifth through seventh transistors T2 and T5 through T7 which require high switching speed may include the first active layer ACT1 made of indium-gallium-zinc-oxide (IGZO).

However, the first, third, fourth and eighth transistors T1, T3, T4 and T8 which require a wide current amount transfer range and high reliability may include the second active layer ACT2 made of indium-gallium-zinc-tin oxide (IGZTO). In other words, the first, third, fourth and eighth transistors T1, T3, T4 and T8 which are directly connected to the pull-up node Q and require high reliability may include a heterogeneous oxide semiconductor material. Accordingly, high reliability and high speed may both be satisfied for each stage STn.

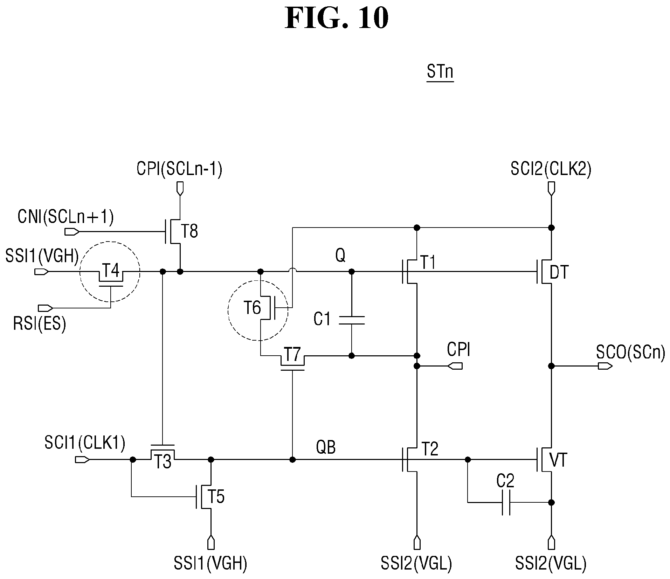

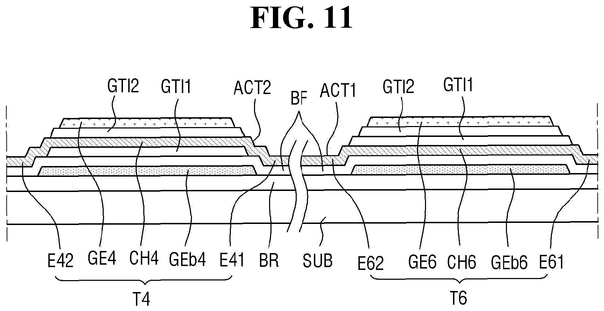

FIG. 10 is a diagram of another embodiment of an nth stage of the scan driver illustrated in FIG. 8. In addition, FIG. 11 is a cross-sectional view illustrating the cross-sectional structure of fourth and sixth transistors of the scan driver illustrated in FIG. 10.

Referring To FIGS. 10 and 11, the fourth transistor T4 directly connected to the pull-up node Q, among the transistors T1 through T8 included in each stage STn may include a second active layer ACT2 including a hetero-oxide semiconductor different from the oxide semiconductor of the first active layer ACT1.

On the other hand, the second and fifth through seventh transistors T2, T5, T6 and T7 indirectly connected to the pull-up node Q among the transistors T1 through T8 included in each stage STn may include the first active layer ACT1 including an oxide semiconductor.

The thin-film transistor layer TFTL of the fourth transistor T4 directly connected to the pull-up node Q may include a first gate electrode GEb1, the interlayer insulating layer BF, the second active layer ACT2 forming a fourth channel region CH4, the first and second gate insulating layers GTI1 and GTI2, and a second gate electrode GE4

The interlayer insulating layer BF is formed to cover the barrier layer BR as well as the first gate electrode GEb1, and the second active layer ACT2 is formed to cover the first gate electrode GEb1 with the interlayer insulating layer BF interposed between them, thereby forming the fourth channel region CH4.

The first gate insulating layer GTI1 is formed to overlap the first gate electrode GEb1 with the second active layer ACT2 interposed between them, and the second gate insulating layer GTI2 is formed to overlap the first gate electrode GEb1 with the first gate insulating layer GTI1 interposed between them.

The second gate electrode GE6 is formed to overlap the first gate electrode GEb1 with the first and second gate insulating layers GTI1 and GTI2 interposed between them, and a first electrode E61 and a second electrode E62 may be defined on one side and the other side of the second active layer ACT2, respectively.

The second active layer ACT2 of the fourth transistor T4 includes a hetero-oxide semiconductor material different from the first active layer ACT1. The second active layer ACT2 may be an oxide semiconductor including indium-gallium-zinc-tin oxide (IGZTO).

Among the transistors T1 through T8 included in each stage STn, the third and fourth transistors T3 and T4 directly connected to the pull-up node Q may include the second active layer ACT2 including a different hetero-oxide semiconductor from the first active layer ACT1, and the first transistor T1 directly connected to the pull-up node Q may include the first active layer ACT1 including an oxide semiconductor.

Alternatively, among the transistors T1 through T8 included in each stage STn, the first transistor T1 directly connected to the pull-up node Q may include the second active layer ACT2 including a different hetero-oxide semiconductor from the first active layer ACT1, and the third and fourth transistors T3 and T4 directly connected to the pull-up node Q may include the first active layer ACT1 including an oxide semiconductor. The fifth transistor T5 may include the second active layer ACT2 including a different hetero-oxide semiconductor from the first active layer ACT1.

The pull-down transistor VT of the output controller OUC may include the first active layer ACT1 including an oxide semiconductor. On the other hand, the pull-up transistor DT of the output controller OUC which is directly connected to the pull-up node Q may include the second active layer ACT2 including a different oxide semiconductor material from the first active layer ACT1 of the pull-down transistor VT.

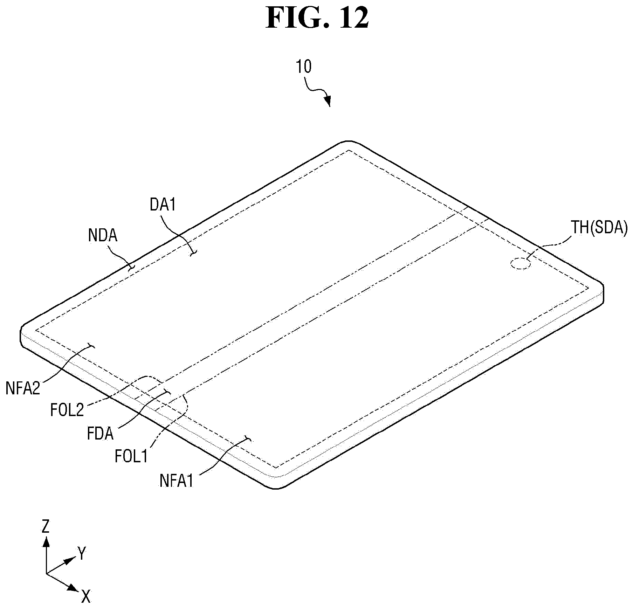

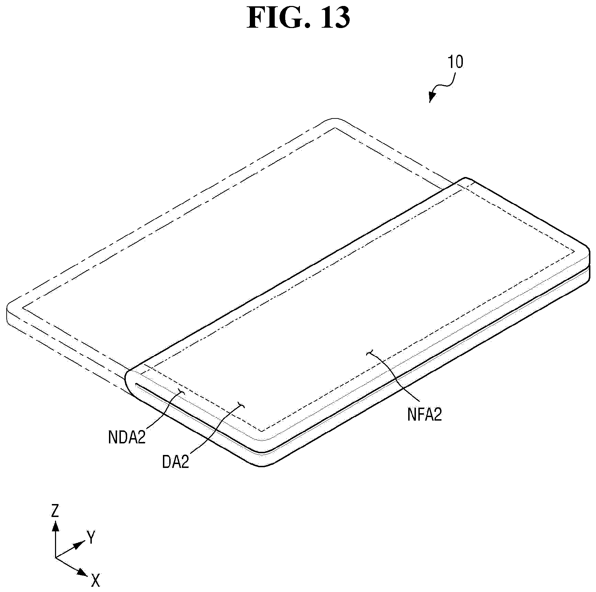

FIGS. 12 and 13 are perspective views of an application example of a display device according to an embodiment of the present disclosure.

FIGS. 12 and 13 illustrate an example in which the display device 10 is applied as a foldable display device that is folded in a first direction (X-axis direction). The display device 10 can maintain both a folded state and an unfolded state. The display device 10 may be folded in an in-folding manner in which a front surface is disposed inside. When the display device 10 is bent or folded in the in-folding manner, portions of the front surface of the display device 10 may face each other. Alternatively, the display device 10 may be folded in an out-folding manner in which the front surface is disposed outside. When the display device 10 is bent or folded in the out-folding manner, portions of a back surface of the display device 10 may face each other.

A first non-folding area NFA1 may be disposed on a side, e.g., a right side of a folding area FDA. A second non-folding area NFA2 may be disposed on the other side, e.g., a left side of the folding area FDA. A touch sensing unit TSU according to an embodiment of the present specification may be formed and disposed on each of the first non-folding area NFA1 and the second non-folding area NFA2.

A first folding line FOL1 and a second folding line FOL2 may extend in a second direction (Y-axis direction), and the display device 10 may be folded in the first direction (X-axis direction). Therefore, since a length of the display device 10 in the first direction (X-axis direction) can be reduced by about half, a user can easily carry the display device 10.

The direction in which the first folding line FOL1 and the second folding line FOL2 extend is not limited to the second direction (Y-axis direction). For example, the first folding line FOL1 and the second folding line FOL2 may also extend in the first direction (X-axis direction), and the display device 10 may also be folded in the second direction (Y-axis direction). In this case, a length of the display device 10 in the second direction (Y-axis direction) may be reduced by about half. Alternatively, the first folding line FOL1 and the second folding line FOL2 may extend in a diagonal direction of the display device 10 between the first direction (X-axis direction) and the second direction (Y-axis direction). In this case, the display device 10 may be folded into a triangular shape.

When the first folding line FOL1 and the second folding line FOL2 extend in the second direction (Y-axis direction), a length of the folding area FDA in the first direction (X-axis direction) may be smaller than a length of the folding area FDA in the second direction (Y-axis direction). In addition, a length of the first non-folding area NFA1 in the first direction (X-axis direction) may be greater than the length of the folding area FDA in the first direction (X-axis direction). A length of the second non-folding area NFA2 in the first direction (X-axis direction) may be greater than the length of the folding area FDA in the first direction (X-axis direction).

A first display area DA1 may be disposed on the front of the display device 10. The first display area DA1 may overlap the folding area FDA, the first non-folding area NFA1, and the second non-folding area NFA2. Therefore, when the display device 10 is unfolded, an image may be displayed toward the front in the folding area FDA, the first non-folding area NFA1, and the second non-folding area NFA2 of the display device 10.

A second display area DA2 may be disposed on the back of the display device 10. The second display area DA2 may overlap the second non-folding area NFA2. Therefore, when the display device 10 is folded, an image may be displayed toward the front in the second non-folding area NFA2 of the display device 10.

In FIGS. 12 and 13, a through hole TH in which a camera SDA is formed is disposed in the first non-folding area NFA1. However, the present disclosure is not limited thereto. The through hole TH or the camera SDA may also be disposed in the second non-folding area NFA2 or the folding area FDA.

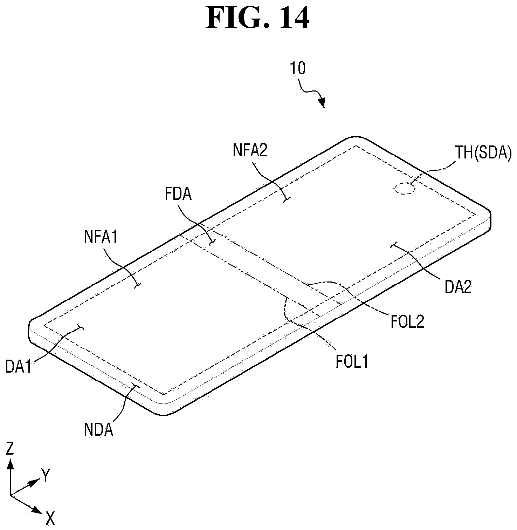

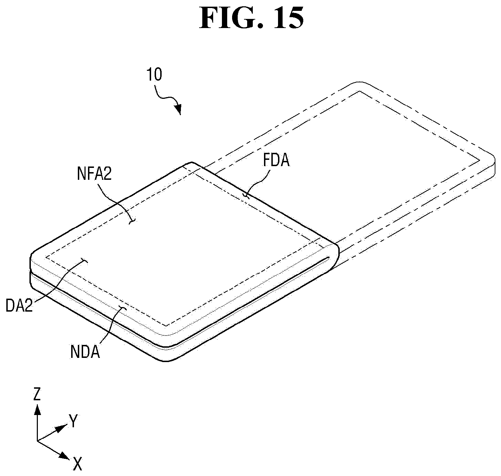

FIGS. 14 and 15 are perspective views of an application example of a display device according to another embodiment of the present disclosure.

FIGS. 14 and 15 illustrate an example in which the display device 10 is applied as a foldable display device that is folded in a second direction (Y-axis direction). The display device 10 can maintain both a folded state and an unfolded state. The display device 10 may be folded in an in-folding manner in which a front surface is disposed inside. When the display device 10 is bent or folded in the in-folding manner, portions of the front surface of the display device 10 may face each other. Alternatively, the display device 10 may be folded in an out-folding manner in which the front surface is disposed outside. When the display device 10 is bent or folded in the out-folding manner, portions of a back surface of the display device 10 may face each other.

The display device 10 may include a folding area FDA, a first non-folding area NFA1, and a second non-folding area NFA2. The folding area FDA may be an area where the display device 10 is folded, and the first non-folding area NFA1 and the second non-folding area NFA2 may be areas where the display device 10 is not folded. The first non-folding area NFA1 may be disposed on a side, e.g., a lower side of the folding area FDA. The second non-folding area NFA2 may be disposed on the other side, e.g., an upper side of the folding area FDA.

A touch sensing unit TSU according to an embodiment of the present specification may be formed and disposed on each of the first non-folding area NFA1 and the second non-folding area NFA2.

The folding area FDA may be an area that is bent with a predetermined curvature at a first folding line FOL1 and a second folding line FOL2. Therefore, the first folding line FOL1 may be a boundary between the folding area FDA and the first non-folding area NFA1, and the second folding line FOL2 may be a boundary between the folding area FDA and the second non-folding area NFA2.

The first folding line FOL1 and the second folding line FOL2 may extend in a first direction (X-axis direction) as illustrated in FIGS. 14 and 15, and the display device 10 may be folded in the second direction (Y-axis direction). Therefore, since a length of the display device 10 in the second direction (Y-axis direction) can be reduced by about half, a user can easily carry the display device 10.

The direction in which the first folding line FOL1 and the second folding line FOL2 extend is not limited to the first direction (X-axis direction). For example, the first folding line FOL1 and the second folding line FOL2 may also extend in the second direction (Y-axis direction), and the display device 10 may also be folded in the first direction (X-axis direction). In this case, a length of the display device 10 in the first direction (X-axis direction) may be reduced by about half. Alternatively, the first folding line FOL1 and the second folding line FOL2 may extend in a diagonal direction of the display device 10 between the first direction (X-axis direction) and the second direction (Y-axis direction). In this case, the display device 10 may be folded into a triangular shape.

When the first folding line FOL1 and the second folding line FOL2 extend in the first direction (X-axis direction) as illustrated in FIGS. 14 and 15, a length of the folding area FDA in the second direction (Y-axis direction) may be smaller than a length of the folding area FDA in the first direction (X-axis direction). In addition, a length of the first non-folding area NFA1 in the second direction (Y-axis direction) may be greater than the length of the folding area FDA in the second direction (Y-axis direction). A length of the second non-folding area NFA2 in the second direction (Y-axis direction) may be greater than the length of the folding area FDA in the second direction (Y-axis direction).

A first display area DA1 may be disposed on the front of the display device 10. The first display area DA1 may overlap the folding area FDA, the first non-folding area NFA1, and the second non-folding area NFA2. Therefore, when the display device 10 is unfolded, an image may be displayed toward the front in the folding area FDA, the first non-folding area NFA1, and the second non-folding area NFA2 of the display device 10.

A second display area DA2 may be disposed on the back of the display device 10. The second display area DA2 may overlap the second non-folding area NFA2. Therefore, when the display device 10 is folded, an image may be displayed toward the front in the second non-folding area NFA2 of the display device 10.

In FIGS. 14 and 15, a through hole TH in which a camera SDA is placed is disposed in the second non-folding area NFA2. However, the present disclosure is not limited thereto. The through hole TH may also be disposed in the first non-folding area NFA1 or the folding area FDA.

In concluding the detailed description, those skilled in the art will appreciate that many variations and modifications can be made to the preferred embodiments without substantially departing from the principles of the present disclosure. Therefore, the disclosed preferred embodiments of the disclosure are used in a generic and descriptive sense only and not for purposes of limitation.

## Claims

1. A scan driver comprising stages which sequentially output scan signals to scan signal lines during an active period of an N-th frame, wherein N is a positive integer, and at least one of the stages comprises:
an output node controller supplying a gate-on voltage to a pull-up node in response to a gate control signal of a display driver; and
an output controller outputting a scan clock signal, which is input to a scan clock terminal, to a connected scan signal line as a scan signal when the gate-on voltage is supplied to the pull-up node,
wherein the output node controller comprises at least one thin-film transistor which includes a first active layer, and is indirectly connected to the pull-up node; and
at least another one thin-film transistor which includes a second active layer in which a hetero-oxide semiconductor material different from the oxide semiconductor material of the first active layer, and is directly connected to the pull-up node.

2. The scan driver of claim 1, wherein the output node controller comprises:
a first transistor turned on when the pull-up node is enabled by the gate-on voltage and supplying any one scan clock signal to a first capacitor connected thereto in parallel;
a second transistor turned on when a pull-down node is enabled by the gate-on voltage and supplying a gate-off voltage to the first transistor;
a third transistor turned on when the pull-up node is enabled by the gate-on voltage and supplying another scan clock signal to the pull-down node;
a fourth transistor turned on in response to a line selection signal of a sensing signal terminal or a previous carry signal and supplying the gate-on voltage to the pull-up node;
a fifth transistor turned on in response to the another scan clock signal and supplying the gate-on voltage to the pull-down node;
a sixth transistor electrically connecting the pull-up node to another transistor or the first capacitor in response to the any one scan clock signal; and
a seventh transistor turned on when the pull-down node is enabled and electrically connecting the sixth transistor to the first capacitor and the first transistor.

3. The scan driver of claim 2, wherein the output controller comprises:
a pull-up transistor turned on by the gate-on voltage of the pull-up node and outputting the any one scan clock signal, which is input to the scan clock terminal, to a scan output terminal and the scan signal line; and
a pull-down transistor turned on by the gate-on voltage of the pull-down node and outputting the gate-off voltage to the scan output terminal and the scan signal line.

4. The scan driver of claim 3,
wherein the pull-down transistor comprises the first active layer comprising an oxide semiconductor, and
wherein the pull-down transistor comprises the second active layer comprising an hetero-oxide semiconductor different from the first active layer.

5. The scan driver of claim 2,
wherein the output node controller further comprises an eighth transistor which disables the pull-up node using the gate-off voltage or any one scan clock signal in response to the next carry signal from a next stage.

6. The scan driver of claim 5, wherein at least one of the second, and fifth through seventh transistors indirectly connected to the pull-up node among the first through eighth transistors included in the output node controller comprises the first active layer comprising an oxide semiconductor, and at least one of the first, third, fourth, and eighth transistors directly connected to the pull-up node among the first through eighth transistors included in the output node controller comprises the second active layer comprising a hetero-oxide semiconductor different from the oxide semiconductor of the first active layer.

7. The scan driver of claim 2, wherein the first transistor has a gate electrode connected to the pull-up node, a first electrode connected to a second scan clock terminal and a second electrode connected to a previous carry terminal and a first electrode of the second transistor, the second transistor has a gate electrode connected to the pull-down node, the first electrode connected to the second electrode of the first transistor and the previous carry terminal and a second electrode connected to a gate-off voltage supply terminal, the third transistor has a gate electrode connected to the pull-up node, a first electrode connected to a first scan clock terminal and a second electrode connected to the pull-down node, the fourth transistor has a gate electrode connected to the sensing signal terminal or the previous carry terminal, a first electrode connected to a gate-on voltage supply terminal and a second electrode connected to the pull-up node, the fifth transistor has a gate electrode connected to the first scan clock terminal, a first electrode connected to the gate-on voltage supply terminal and a second electrode connected to the pull-down node, the sixth transistor has a gate electrode connected to the second scan clock terminal, a first electrode connected to the pull-up node and a second electrode connected to the second electrode of the first transistor or a first electrode of the seventh transistor, and the seventh transistor has a gate electrode connected to the pull-down node, the first electrode connected to the second electrode of the sixth transistor and a second electrode connected to the second electrode of the first transistor and the first capacitor.

8. The scan driver of claim 7, wherein the output controller comprises:
a pull-up transistor having a first electrode connected to the second scan clock terminal, a gate electrode connected to the pull-up node, and a second electrode connected to the scan output terminal; and
a pull-down transistor having a first electrode connected to the scan output terminal, a gate electrode connected to the pull-down node, and a second electrode connected to a gate-off voltage supply terminal.

9. The scan driver of claim 8, wherein the pull-down transistor comprises the first active layer comprising an oxide semiconductor, and the pull-up transistor comprises the second active layer comprising a hetero-oxide semiconductor different from the oxide semiconductor of the first active layer.

10. The scan driver of claim 7, wherein the output node controller further comprises an eighth transistor having a gate electrode connected to a next carry terminal, a first electrode connected to the previous carry terminal or the gate-off voltage supply terminal, and a second electrode connected to the pull-up node.

11. The scan driver of claim 10, wherein at least one of the second, and fifth through seventh transistors indirectly connected to the pull-up node among the first through eighth transistors included in the output node controller comprises the first active layer comprising an oxide semiconductor, and at least one of the first, third, fourth, and eighth transistors directly connected to the pull-up node among the first through eighth transistors included in the output node controller comprises the second active layer comprising a hetero-oxide semiconductor different from the oxide semiconductor of the first active layer.

12. The scan driver of claim 7, wherein the first active layer comprises indium-gallium-zinc-oxide, and the second active layer comprises indium-gallium-zinc-tin oxide.

13. A display device comprising:
a plurality of pixels arranged in a display area of a display panel;
a touch sensing unit mounted on the front of the display panel and integrally formed with the display panel;
a touch driver sensing a touch using a plurality of touch electrodes arranged in the touch sensing unit;
a display driver controlling data voltages supplied to the pixels and image display timing of the pixels; and
a scan driver sequentially driving scan signal lines, which are connected to the pixels, in response to a gate control signal from the display driver,
wherein the scan driver comprises stages which sequentially output scan signals to the scan signal lines during an active period of an N-th frame, wherein N is a positive integer, and at least one of the stages comprises:
an output node controller supplying a gate-on voltage to a pull-up node in response to a gate control signal of a display driver; and
an output controller outputting a scan clock signal, which is input to a scan clock terminal, to a (?) connected scan signal line as a scan signal when the gate-on voltage is supplied to the pull-up node,
wherein the output node controller comprises at least one thin-film transistor comprising a first active layer and is indirectly connected to the pull-up node; and
at least another one thin-film transistor comprising a second active layer comprising an oxide semiconductor material different from the first active layer, and is indirectly connected to the pull-up node.

14. The display device of claim 13, wherein the output node controller comprises:
a first transistor turned on when the pull-up node is enabled by the gate-on voltage and supplying any one scan clock signal to a first capacitor connected thereto in parallel;
a second transistor turned on when a pull-down node is enabled by the gate-on voltage and supplying a gate-off voltage to the first transistor;
a third transistor turned on when the pull-up node is enabled by the gate-on voltage and supplying another scan clock signal to the pull-down node;
a fourth transistor turned on in response to a line selection signal of a sensing signal terminal or a previous carry signal and supplying the gate-on voltage to the pull-up node;
a fifth transistor turned on in response to the another scan clock signal and supplying the gate-on voltage to the pull-down node;
a sixth transistor electrically connecting the pull-up node to another transistor or the first capacitor in response to the any one scan clock signal; and
a seventh transistor turned on when the pull-down node is enabled and electrically connecting the sixth transistor to the first capacitor and the first transistor.

15. The display device of claim 14, wherein the output controller comprises:
a pull-up transistor turned on by the gate-on voltage of the pull-up node and outputting the any one scan clock signal, which is input to the scan clock terminal, to a scan output terminal and the scan signal line; and
a pull-down transistor turned on by the gate-on voltage of the pull-down node and outputting the gate-off voltage to the scan output terminal and the scan signal line.

16. The display device of claim 14, wherein the output node controller further comprises an eighth transistor which disables the pull-up node using the gate-off voltage or any one scan clock signal in response to the next carry signal from a next stage.

17. The display device of claim 14, wherein the first transistor has a gate electrode connected to the pull-up node, a first electrode connected to a second scan clock terminal and a second electrode connected to a previous carry terminal and a first electrode of the second transistor, the second transistor has a gate electrode connected to the pull-down node, the first electrode connected to the second electrode of the first transistor and the previous carry terminal and a second electrode connected to a gate-off voltage supply terminal, the third transistor has a gate electrode connected to the pull-up node, a first electrode connected to a first scan clock terminal and a second electrode connected to the pull-down node, the fourth transistor has a gate electrode connected to the sensing signal terminal or the previous carry terminal, a first electrode connected to a gate-on voltage supply terminal and a second electrode connected to the pull-up node, the fifth transistor has a gate electrode connected to the first scan clock terminal, the first electrode connected to the gate-on voltage supply terminal and a second electrode connected to the pull-down node, the sixth transistor has a gate electrode connected to the second scan clock terminal, a first electrode connected to the pull-up node and a second electrode connected to the second electrode of the first transistor or a first electrode of the seventh transistor, and the seventh transistor has a gate electrode connected to the pull-down node, the first electrode connected to the second electrode of the sixth transistor and a second electrode connected to the second electrode of the first transistor and the first capacitor.

18. The display device of claim 17, wherein the output controller comprises:
a pull-up transistor having a first electrode connected to the second scan clock terminal, a gate electrode connected to the pull-up node, and a second electrode connected to the scan output terminal; and
a pull-down transistor having a first electrode connected to the scan output terminal, a gate electrode connected to the pull-down node, and a second electrode connected to a gate-off voltage supply terminal.

19. The display device of claim 17,
wherein the output node controller further comprises eighth transistor having a gate electrode connected to a next carry terminal, a first electrode connected to the previous carry terminal or the gate-off voltage supply terminal, and a second electrode connected to the pull-up node.

20. The display device of claim 19,
wherein at least one of the second, and fifth through seventh transistors indirectly connected to the pull-up node among the first through eighth transistors included in the output node controller comprises a first active layer comprising an oxide semiconductor, and at least one of the first, third, fourth, and eighth transistors directly connected to the pull-up node among the first through eighth transistors included in the output node controller comprises the second active layer comprising a hetero-oxide semiconductor different from the oxide semiconductor of the first active layer.
